Europäisches Patentamt

European Patent Office

Office européen des brevets

(11) Publication number: **0 244 246**
A2

# EUROPEAN PATENT APPLICATION

(21) Application number: **87303881.4**

(22) Date of filing: **30.04.87**

(51) Int. Cl.³: **G 03 F 1/00**

(30) Priority: **02.05.86 US 858672**

(43) Date of publication of application:
**04.11.87 Bulletin 87/45**

(84) Designated Contracting States:
**AT BE CH DE ES FR GB IT LI NL SE**

(71) Applicant: **HAMPSHIRE INSTRUMENTS, INC**
**10, Carlson Road**
**Rochester New York 14610(US)**

(72) Inventor: **Plotnik, Irving**
**295 Turnpike Road Apartment 702**
**Westboro Massachusetts 01581(US)**

(74) Representative: **Miller, Joseph et al,**
**J. MILLER & CO. Lincoln House 296-302 High Holborn**
**London WC1V 7JH(GB)**

(54) A method of making a dimensionally stable X-ray mask.

(57) A method of making a dimensionally stable mask suitable for use in X-ray lithography involves preparing a mask blank comprising a series of continuous laminae (4, 6, 8) which include a boron-doped epitaxial silicon barrier layer (6), which ultimately forms the support of an X-ray absorbing metal deposited thereon. This deposition is effected in such a way that the metal is chemically bonded to the boron-doped epitaxial silicon barrier layer (6) in the finished pattern it is to adopt. The underlying substrate (4), which comprises a silicon wafer on one surface of which the boron-doped eptiaxial silicon layer (6) is grown, is etched away from beneath this layer (6) either before or after the X-ray absorber material (10) has been vapour deposited thereon.

FIG.3a

FIG. 3d

- 1 -

"A method of making a dimensionally stable X-ray mask"

The present invention relates to a method of making a mask suitable for use in X-ray lithography.

The manufacture of microcircuitry, such as semiconductor integrated circuits, has evolved through the use of lithographic imaging techniques. These lithographic techniques have led to the development of various devices with extremely fine features and low defect density such as integrated circuit memory, integrated circuit logic and magnetic bubble memory technology. The ability to produce these devices both efficiently and cost effectively has dramatically reduced the price of such components and has thus led to their greater application in various consumer as well as industrial products. In a typical lithographic process, a pattern is produced on a radiation sensitive material, commonly termed a "resist". This resist is initially bonded to a semiconductor wafer. The resist is then exposed to imaging energies through a mask. The mask is interposed between the resist and the radiation source. The resolution which is ultimately obtainable in the pattern delineated by the resist is thus limited by, among other factors, the mask. In order for the semiconductor wafer to be cost effectively manufactured, it is necessary faithfully to reproduce the mask pattern onto the resist.

Known processes, such as optical electron beam lithography are being used commercially. X-ray lithography is considered as a

promising alternative because it offers the possibilities of obtaining both fine features (less than one micron) and high throughput, and because it is potentially less expensive than electron beam based imaging techniques. The resolution obtained in a pattern-delineated resist is, of course, limited by the integrity of the mask structure and tolerances of the mask features. Hence, efforts have been devoted to developing X-ray lithographic processes which include fabrication of suitable X-ray mask structures. A typical mask structure comprises an X-ray transparent substrate in conjunction with an X-ray absorbing pattern.

The following list of patents is representative of the patent literature directed to this technology:
4,522,842; 4,513,203; 4,393,127; 4,385,434; 4,378,629, 4,370,194; 4,360,586; 4,344,153; 4,301,237; 4,293,624; 4,287,235; 4,260,670; 4,256,787; 4,224,630; 4,177,476; 4,080,267; 4,061,829; 4,035,522; 4,019,109; 3,975,252; and 3,892,973, (all of the foregoing being hereby incorporated by reference in their entirety).

A recent summary in the technical literature has concisely described the advances in X-ray mask technology, see Shimkunas, A. R., Advances in X-Ray Mask Technology, SOLID STATE TECHNOLOGY, September 1984. The Shimkunas article contains a brief discussion of X-ray lithography and of the mask blanks typically used in the preparation of X-ray masks for x-ray lithography. According to Shimkunas, the X-ray mask blank typically consists of a thin film membrane structure which is held in tension by a supporting frame, usually a ring. The portion of the membrane structure which is X-ray transparent is also the portion which is in tension and supports the X-ray absorber pattern. The transparent portion may be a single layer or a multilayer element. In the most common type of additive patterning, a plating base is applied to an X-ray transparent membrane, a vertical-wall stencil is formed thereon and an electron or X-ray absorbing metal, typically gold, is electroplated through the stencil openings.

According to Shimkunas, it is essential that the transparent membrane has sufficient strength not to fracture under the degree of tension required for flatness. It is thus important to choose a membrane material with high tensile or yield strength. It is also equally important to control the membrane tension to a level comfortably below that of its yield limit. The requisite tension of this membrane may be obtained in one of two ways: either the membrane may be formed in an unsupported, slack form and then mechanically stretched over a blank frame to the desired tension or, preferably, the membrane may be deposited form a vapour onto a sacrificial substrate to a level of residual stress determined by the process parameters. the sacrificial substrate is subsequently etched away chemically leaving a taut membrane. Membranes of silicon oxynitride can be prepared in this latter fashion by a combination of anisotropic and isotropic etching of silicon, coated with boron-doped epitaxial silicon. In order to protect the silicon oxynitride film from the chemical etch, this film can be pretreated by coating a silicon nitride layer. The silicon nitride will thus protect the oxynitride layer from the etchant and the boron-doped silicon layer protects the emerging membrane from breaking during the etching process. After the etching process has been completed, the epitaxial silicon layer is removed by further etching in a hydrofluoric-nitric acid mixture.

The advantages of X-ray lithography are well-known, and this technique is widely considered to be the most appropriate for avoiding the limitations of optical and electron beam lithography when producing a pattern having submicron features. The greatest and most obvious advantage of X-ray lithography lies in its high

0244246

- 4 -

image resolution because of the short wavelengths of X-rays. Moreover, this technology is not affected by depth-of-focus problems or by reflection and scattering effects which are a problem with optical and electron beam lithographic techniques. One of the major problems which has prevented the widespread commercial adoption of X-ray lithography, however, is the difficulty in fabrication of the X-ray mask. The X-ray mask must be distortion free and capable of being patterned to submicron dimensions. It is also recognised that the masks which are required for X-ray lithographic systems could not have evolved from optical lithography mask making because these methods require significantly different materials and designs. For example, glass substrates which are typically transparent to ultraviolet light are relatively opaque to X-rays, especially the so-call "soft" X-rays, at thicknesses greater than ten micrometers.

Despite the progress which has been made to date, most wafer processing experts agree that X-ray lithography is still far from being a widely used production technique. Semiconductor manufacturers, who presently rely on optical lithography, generally, agree that more development is needed in many areas of X-ray lithography before it will be commercially acceptable. For example, brighter X-ray sources are needed for production use, and X-ray resists suitable for production use must first be developed. The principal detrimental factor affecting currently available X-ray resists is the relatively poor production quality images which are produced from these resists. This is particularly true for negative resists. It is becoming increasingly recognized that if X-ray lithography is to succeed, increasing efforts must be made in mask fabrication, including the fabrication of X-ray blanks (mask substrates) and the masks themselves. Until these key ingredients of x-ray lithography are perfected, this technology will not advance much beyond its present penetration into the marketplace today.

The major problems which are typically associated with the successful development of X-ray masks is the relative lack of dimensional and thermal stability; the lack of reproducibility; and, the relative expense in their manufacture. These problems are both process and materials related. For example, where chemical vapour deposition of tungsten is attempted through a silicon dioxide stencil, the tungsten deposit will encroach, to some degree, underneath the silicon dioxide protected area. This tends to imply rapid consumption of silicon at these regions. As is readily recognised, such encroachment can adversely affect the acuity of the pattern.

Another problem encountered in chemical vapour deposition of tungsten is manifest through the creation of "tunnels" or "worm holes". Worm holes are typically less than 0.1 micrometer and therefore can be tolerated in X-ray lithography. Although they indicate problems with the tungsten chemical vapour deposition process, they do not present a serious problem for x-ray lithography because of their size.

The problems associated with dimensional and thermal stability of masks suitable for use in X-ray lithography have resulted in significant amounts of research devoted to its solution and the issuance of numerous patents in this area. U.S. Patent 4,393,127, for example, is directed to the fabrication of a structure for masking or shaping an electron beam or X-rays. The invention described in this patent specifically addresses the problem of mechanical and thermal stability of the mask. The structures which are fabricated according to this patented process are purportedly suitable in the manufacture of microelectronic devices. The approach adopted by Patentee for resolving this and related problems involves the initial formation of a mask blank consisting of a microcrystalline silicon layer wafer, a silicon dioxide coating on one surface of the wafer (underside surface) and modification of the opposite surface (topside surface) of the wafer by doping with boron, (typically in a concentration of greater than $10^{20}$ atoms/cm$^3$) to a depth of 1.5 to 3 micrometers). The processing sequence for creation of the mask from this blank is illustrated in Figures 5A-G of the above-mentioned US Patent No 4,393,127. The initial step of the sequence involves modification of the silicon dioxide layer on the underside of the wafer so as to expose the monocrystalline silicon wafer. The silicon dioxide on the underside of this blank thus serves as an etching mask. The region of this wafer exposed through this etching mask can then be removed chemically. The extent to which this wafer is removed is apparently controlled (through some undisclosed process) to avoid removal of the boron-doped surface modified portion of the wafer. A second silicon dioxide etching layer is then deposited upon the boron modified surface of the blank. Reinforcing layers are also added to the underside of the blank. The silicon modified etching layer is exposed to imaging energies and selectively removed thereby exposing a portion of the boron-doped monocrystalline silicon wafer. According to the Patentee, this etching is achieved by RIE techniques. The exposed boron-doped monocrystalline silicon is also etched by RIE techniques. The exposed regions of the boron-doped monocrystalline silicon are thus totally removed in the exposed areas. Subsequently, an X-ray absorber (e.g. tungsten) is nonselectively deposited upon the surface of the imaged blank. After an annealing process, the tungsten chemically reacts with the boron-doped monocrystalline silicon, forming a tungsten silicide. The tungsten deposit on the supporting silicon dioxide layer can then be removed by selective wet chemical etching resulting in the structure shown in Figure 5G of the above-mentioned patent.

The process described in this prior US Patent has both its advantages and disadvantages. One of its disadvantages is the relatively high consumption of X-ray absorbing metal in the fabrication of the resultant mask. In addition, the boron doping of the monocrystalline silicon wafer is relatively non-uniform in that there is no clear transition between the reactive surface and the more interior regions of the wafer itself. This can create problems regarding reproducibility of this process since the absence of such a clear transition between the doped and undoped regions of the wafer introduces potential imprecision in the chemical etching step of the process.

The invention as claimed is intended to provide a dimensionally stable X-ray mask suitable for use in X-ray lithography and wherein the X-ray absorber metal and X-ray transparent membrane are chemically bonded to one another.

According to the present invention there is provided a method of fabrication of a dimensionally stable X-ray mask comprising the steps of producing a mask blank consisting of a support member on which is formed a membrane of a material which is substantially transparent to X-rays, overlaying the membrane with a layer of etchable material, selectively removing etchable material from the said layer by etching out a selected pattern therefrom, and depositing an X-ray absorbing material onto the surface of the said membrane exposed through the said etchable layer to form an X-ray absorbing pattern, characterised in that the said X-ray absorbing material is selectively deposited by chemical vapour deposition techniques in a pattern determined by the etched pattern in the said etchable layer under conditions such as to form a bonding reaction product between the mebrane and the X-ray absorbing material.

The method of the invention is thus different from the process known from US Patent 4,393,127 in that the X-ray absorbing material is directly deposited onto the membrane in the pattern it is to have in the finished mask and under conditions such as to form a bonding reaction product between them. This mask blank is prepared by initially providing a silicon wafer, a barrier layer is then formed upon one surface of this wafer by epitaxially growing a boron-doped silicon coating thereon. The term "barrier layer", as used throughout this specification, is intended to define a coating which is chemically distinct in its reactivity from that of the silicon wafer. This coating can vary in thickness from about 0.3 to about 3 micrometers. The level of boron doping will generally be sufficient to provide an etch barrier, so that when the silicon wafer is exposed to a suitable chemical etchant the etching will cease upon reaching the boron-doped barrier layer; thereby yielding an X-ray transmissive membrane.

In the preferred embodiments of this invention, the concentration of boron doping is in the range of about $5 \times 10^{19}$ atoms/cm$^{-3}$ to about $2.5 \times 10^{20}$ atoms/cm$^{-3}$. A silicon dioxide (SiO$_2$) film is then deposited upon the boron-doped barrier layer. A resist, in turn, is layered directly upon this silicon dioxide coating thereby completing fabrication of the mask blank.

The method of fabrication of the mask then continues along one of two routes. In the first the resist layer is selectively exposed to imaging energies from an electron beam, the image pattern developed in the conventional manner and the exposed SiO$_2$ coating etched to form a stencil. The selective removal of the silicon dioxide is sufficient to expose the boron-doped epitaxial silicon barrier layer. Once this has been achieved, the remaining resist can then be removed from the remaining silicon dioxide coating. The exposed regions of the boron-doped epitaxial silicon barrier layer are then contacted with reactive tungsten vapour in accordance with conventional low pressure, chemical vapour deposition techniques, and the tungsten deposit which is formed on the imaged mask blank conforms in geometry to the pattern which has been stencilled into the silicon dioxide coating. Upon completion of the tungsten deposition, the balance of the silicon dioxide coating can be removed from the barrier layer. This removal is typically achieved by plasma etching techniques. The underlying substrate silicon wafer in the area of the deposited tungsten is then removed from the underside of the wafer now by selective chemical etching with alkali (e.g. potassium hydroxide) or other suitable etchants (e.g. ethylene diamene pyrocatechol) to leave a boron-doped epitaxial silicon membrane supporting a pattern of deposited tungsten bonded thereto upon deposition.

In the second route the membrane is first separated from the silicon wafer substrate before the tungsten is deposited. It has been surprisingly discovered that unexpected advantages are obtained by forming the membrane first and then patterning the absorber metal onto it. In this case the boron-doped epitaxial silicon layer is first grown and then $SiO_2$ layers are deposited on both front and back sides of the wafer. The active area (where the pattern is to be formed) is then defined by opening a hole in the $SiO_2$ on the wafer's underside by etching with KOH or ethylene diamine pyrocatechol. Once the membrane is defined by removal of the underlying substrate, the process steps, for patterning the metal absorber, proceed as described above.

The unexpected advantages of forming the membrane first are that, during etching, the region of the silicon wafer where the membrane is formed is allowed physically to relax. Thus, any stress mismatches between the epitaxial silicon layer and silicon wafer readjust to their minimum energy stage. Etching the supporting silicon wafer drives the microscopic realignments of the epitaxial silicon layer relative to the underlying silicon. When the epitaxial silicon layer relaxes, there is some distortion and movement thereof, taking the metal absorber with it. The metal absorber has now assumed a new position slightly different from where it was originally deposited, albeit only a very small distance (e.g. 0.1 - 0.25 micrometers). Consequently, forming the membrane first, then patterning the metal, avoids this distortion of the metal absorber pattern giving an even more accurately patterned mask.

One way of carrying out the invention is described in detail below with reference to drawings which illustrate only one specific embodiment, and in which:

Figure 1 is a perspective view of an X-ray mask prepared by the method of this invention.

Figure 2 is a cross-sectional view through the X-ray mask of the invention, taken on the line 2-2 of Figure 1; and

Figures 3a to 3d are a series of cross-sections through a mask blank at various stages in the preparation of the X-ray mask of this invention.

The method of this invention is illustrated hereinafter in the preparation of an X-ray mask suitable for additive patterning X-ray lithography. The preliminary step in the fabrication of this mask is the construction of an appropriate mask blank. This mask blank is formed from a silicon wafer by progressive modification of this wafer.

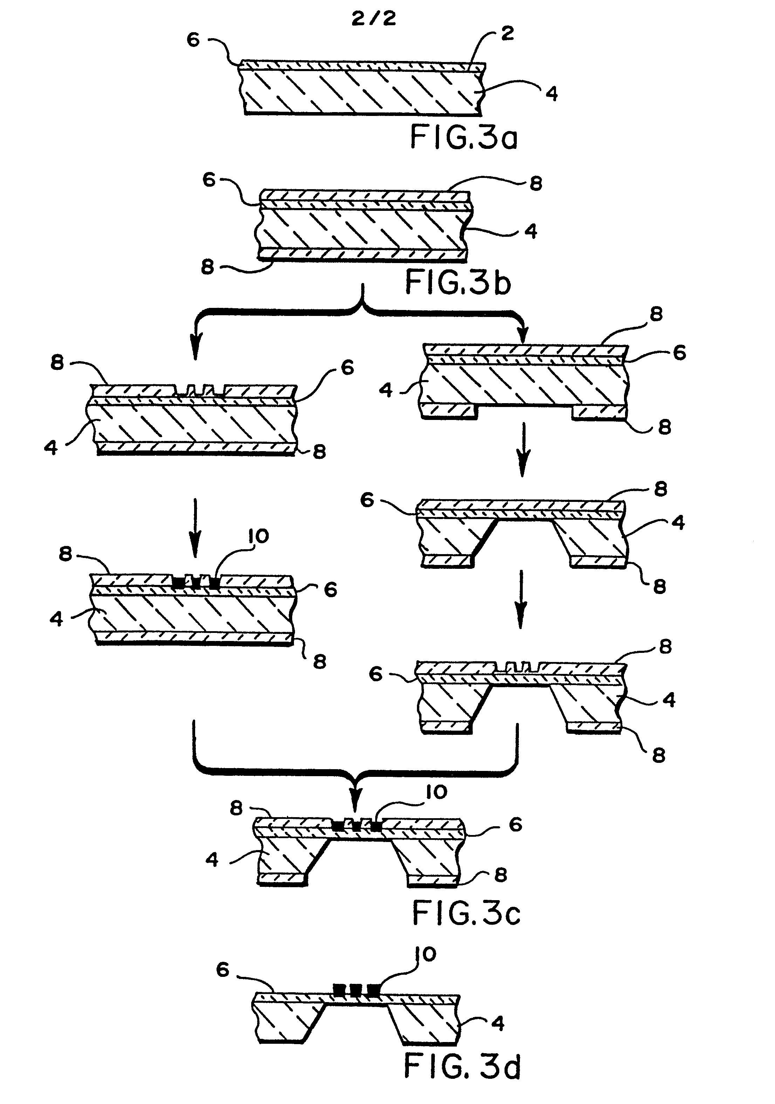

As more fully illustrated in Figures 3a-3d, the topside 2 of a wafer 4 is initially modified by growing thereon, a boron-doped epitaxial silicon barrier layer 6. This barrier layer is formed under standard process conditions, utilising conventional apparatus and techniques, see, for example, U. S. Bank, "Mass Spectrometric Studies of Chemical Reactions and Transport Phenomena in Silicon Epitaxy," Proceedings of the Sixth Int. Conf. on CVD 1977, Electrochem. Soc., 1977; R. Reif, T. I. Kamins, and K. C. Saraswat, "A Model for Dopant Incorporation into Growing Silicon Epitaxial Films," J. Electrochem. Soc. 126, 1979; P. H. Langer and J. I. Goldstein, "Boron Autodoping during Silane Epitaxy," J. Electrochem. Soc. 124, 592 (1977); R. B. Herring, "Advances in Reduced Pressure Silicon Epitaxy," Solid State Technol., 22, 75, 1979; and U. S. Bank and E. P. Miller, "A New Reactor for Silicon Epitaxy," Proceedings of the 7th Int. Conf. on CVD 1979, Electrochem. Soc., 1979, (all of the foregoing being hereby incorporated by reference in their entirety).

In the preferred embodiments of this invention, the reactive environment in which such epitaxial growth takes place comprises a gaseous atmosphere of $B_2H_6$ and $SiCl_4$ at a relative concentration of approximately 1:10 parts by weight. The substrate temperature is carefully controlled during barrier layer formation and determines the rate of deposition of the barrier layer onto the silicon wafer. Substrate temperatures in the range of from about 900-1250°C result in a deposition rate of 0.2 to about 1.5 micrometers per minute. The barrier layer growth on this silicon wafer is carefully controlled in order to assure a coating of appropriate thickness; preferably in the range of from about 0.5 to about 3 micrometers. The optimum layer thickness is functionally related to the anticipated pattern dimension and the anticipated energy level of the X-ray source (e.g. soft X-rays or hard X-rays). The thickness of this barrier layer must, thus, be thick enough to provide clear definition between the silicon membrane and the X-ray absorber which is to be deposited thereon, of adequate mechanical strength to insure both dimensional stability and a taut surface, and it must be transparent to the imaging energies of the X-rays with which it is intended to be used.

Once a barrier layer of appropriate thickness has been formed on one surface, the upper face of the silicon wafer, a silicon dioxide layer 8 is then deposited on the surface of this barrier layer and on the underside of the silicon wafer. This silicon dioxide layer, or stencil layer, is preferably formed by low pressure chemical vapour deposition (LPCVD) or plasma-enhanced chemical vapour deposition (PECVD) techniques. The atmosphere within the reactor contains a gaseous mixture of $SiH_4$ and $O_2$. The relative concentration of these ingredients within the reactor is in the range from about 1:1.5 to about 1:2.5. The substrate temperature, that is, the temperature of the barrier layer and/or the underside of the wafer, is maintained in the range of from about 400 to about 600°C. This substrate temperature is conducive to an $SiO_2$ deposition rate of from about 800 to about 100 angstroms per minute. The details of this deposition process and the equipment and techniques which are used in such deposition are more fully described in the technical literature, see for example J. R. Ligenza, "Silicon Oxidations in an Oxidation Plasma Excited by Microwaves," J. Appl. Phys., 36, 2703 (1965); and A. K. Ray and A. Reisman, "The Formation of $SiO_2$ in an RF Generated Oxygen Plasma," J. Electrochem. Soc. 128, 2466 (1981), (all of which are hereby incorporated by reference in their entirety).

In Figure 3 there are illustrated two processing pathways in converting the blank of Figure 3b to the semi-finished product of Figure 3c. In the processing pathway illustrated on the left, the silicon dioxide stencil layer on the topside of the blank is covered with a tri-layer resist (not shown), the resist is exposed to an energy pattern with an electron beam, and then developed and the resist material in the exposed areas thereby removed thus exposing the underlying silicon dioxide layer. This underlying silicon dioxide layer is then etched away with a reactive ion etching technique to the level of the doped epitaxial silicon layer which acts as a barrier. The resist is then removed by solvent stripping and the patterned surface of the resultant structure subjected to chemical vapour deposition with tungsten.

After this, the portion of the silicon wafer beneath the area of the image pattern is removed by selective chemical etching techniques which involve initially exposing the silicon by reactive ion etching of an area of the silicon dioxide coating on the underside again defined by exposing and developing a photoresist coated on for this purpose. Then, after exposure of the silicon to buffered hydrofluoric acid the exposed silicon surface can be etched away by a suitable chemical etchant (e.g. a mixture of pyrocatechol, ethylene diamime and distilled water). This solution is held at a constant temperature of about 115°C. The etching of the underside of the wafer, at this temperature, proceeds at the rate of about 60-100 micrometers per hour. This etching is self-limiting in that the boron-doped epitaxial layer is relatively impervious to the etchant. This same etching technique can also be used to remove the remnants of the $SiO_2$ stencil on the upper face. Under the conditions specified above, such consumption of the stencil will proceed at the rate of about 200 to 500 angstroms per minute.

In the alternative processing pathway (hereinafter referred to as the membrane process) illustrated on the right of Figure 3, the $SiO_2$ layer on the underside of the mask blank is covered with a resist (not shown) exposed to imaging energies, the extent of such exposure being intended to define the area of the membrane. Following such exposure, the exposed region of the resist is developed and the resist in the exposed area removed thereby exposing the silicon dioxide coating beneath. This exposed portion of the silicon dioxide coating can then be removed, again by reactive ion etching techniques, thus exposing the underside of the silicon wafer. After this the silicon wafer 4 itself is removed with a suitable chemical etchant. The removal of the wafer 4 continues until the underside of the boron-doped epitaxial silicon layer 6 is exposed. This procedure first involves the reactive ion etching of the $SiO_2$ layer in a $CHF_3$ discharge plasma, which etching process generally requires careful control over chamber pressure and gas flow rate. In the preferred embodiments of this invnetion, the chamber pressure is maintained at about ten mtorr and the gas flow rate (the rate of flow of the $CHF_3$) at ten sccm (standard cubic centimeters per minute). During the etching process, an electrical bias of 600 volts is maintained across the $SiO_2$ layer which results in an etching rate of approximately 300 angstroms per minute. An AZ-type sacrificial resist (commercially available from Shipley, Inc., Newton, Massachusetts), can be employed as the mask for this etching process. The sacrificial resist is selected for its greater resistance to the etchant than the $SiO_2$ layer in order to insure adequate patterning of the $SiO_2$ layer. In the preferred embodiments of this invention, the sacrificial resist will be at least five times as resistant to the RIE etching as the $SiO_2$ layer. The etching of the $SiO_2$ layer is sufficient effectively to remove this layer in the exposed areas to the level of the underlying barrier layer.

A tri-layer resist is then applied to the silicon dioxide coating on the upper face of the blank. This resist is exposed by an electron beam to an energy pattern in the manner described previously; the resist is developed, the silicon dioxide coating etched, and the unexposed portions of the resist subsequently stripped from the underlying silicon dioxide coating prior to deposition of the X-ray absorber. The surface of the stencil is then carefully cleaned and the resultant structure is placed in a chemical vapour deposition chamber where tungsten is deposited as previously described. Preferably the X-ray absorbing metal is tungsten and the deposition on the barrier layer is achieved using low pressure chemical vapour deposition techniques. The techniques which are used in the deposition of the X-ray absorber are similar to those which are described above for deposition of the $SiO_2$ layer except that here an X-ray absorber pattern is defined through the $SiO_2$ stencil by low pressure, selective chemical vapour deposition of the tungsten. This process is additive, hence precisely filling the openings defined in the $SiO_2$ stencil. Deposition of the tungsten is highly selective and occurs only in those areas where the barrier layer has been exposed and not upon the surface of the stencil itself. Following deposition of the tungsten the remaining portions of the silicon dioxide stencil are removed by selective ion etching, producing the structure illustrated in Figure 3(d).

The extent of deposition is sufficient to conform the deposit to the geometry of the pattern which has been formed within the stencil. The deposition of the tungsten upon the barrier layer follows a two-stage chemical reaction. This reaction is illustrated as follows:

$$(1) \quad 2WF_6 + 3Si \xrightarrow{\quad 300°C \quad} 2W + 3SiF_4$$

$$(2) \quad WF_6 + 3H_2 \xrightarrow{\quad 300°C \quad} W + 6HF$$

The equipment and techniques used in performing the low-pressure chemical vapour deposition of tungsten on the barrier layer are well known and set forth in the technical literature, see for example, M. L. Green and R. A. Levy, "Chemical Vapour Deposition of Metals for Integrated Circuit Applications" J. of Metals, June 1985; and T. Moriya, K. Yamada, Y. Tsunashima, and M. Kashiwagi, "A New Encroachment-Free Tungsten CVD Process with Superior Selectivity, Extended Abstracts of the 15th Conf. on Solid State Devices & Materials, Tokyo, 1983, pp. 225-228, (all of which are hereby incorporated by reference in their entirety).

The gas pressure for the tungsten hexafluoride within the deposition chamber is in the range from about 2.5 to about $5 \times 10^4$ torr and from about 0.15 to about 0.35 torr for $H_2$. Typical flow rates within the deposition chamber are 10 cubic centimeters per minute for hydrogen. The rate of deposition, as indicated above, is controlled through careful selection of the substrate temperature. In the preferred embodiments of this invention, the substrate temperature is maintained in the range from about 300-400°C to achieve a deposition rate of from about 50 to about 200 angstroms per minute.

Following the selective chemical vapour deposition of the tungsten within the contours of the stencil, the stencil itself can be removed, for example by plasma etching or reactive ion etching techniques. Plasma etching is somewhat similar to, but yet rather distinct in both operation and result from reactive ion etching (RIE). The key difference is that the pressure within the plasma etch chamber is much higher than in an RIE chamber so that etching takes place isotropically rather than anisotropically as with RIE. Plasma etching has been employed in semiconductor fabrication: See, for exmaple S. M. Irving, KI. E. Lemons, and G. E. Bobos, "Gas Plasma Vapour Etching Process," U.S. Patent 3,615,956 (1971); and A. Jacob, "Fluorocarbon Composition for Use in Plasma Removal of Photoresist Material from Semiconductor Devices," U.S. Patent 3,951,843 (1976).

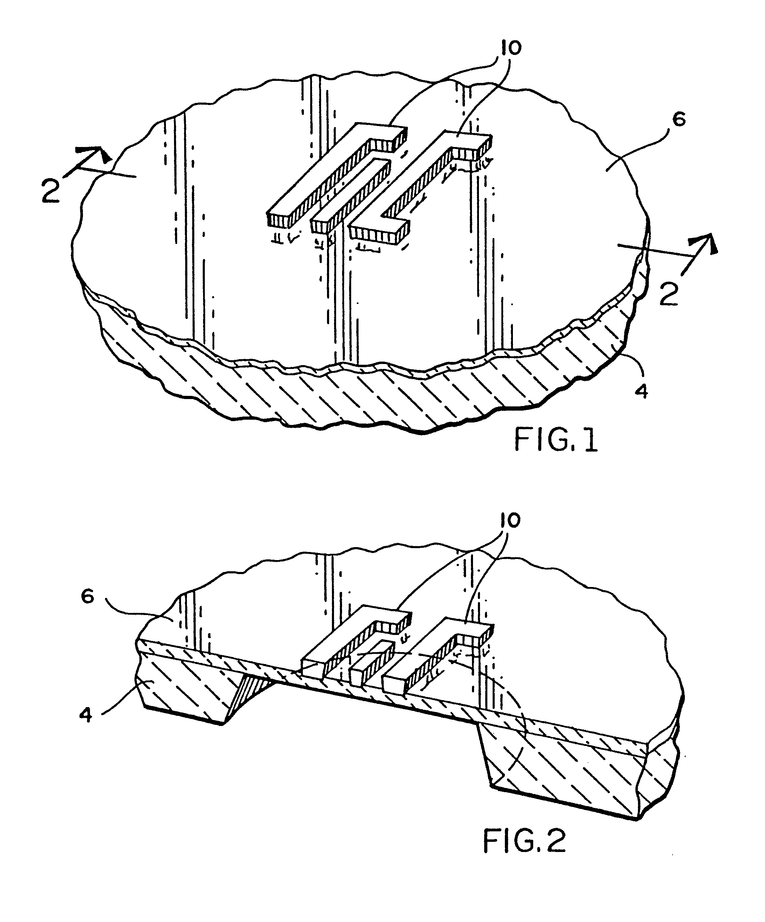

The mask which results from either of the two alternative foregoing processes is illustrated in Figures 1 and 2. Figure 1 represents a perspective view of a mask which can be prepared in accordance with the process of this invention. Figure 2 represents a cross-section through the mask of Figure 1 at line 2-2.

The mask prepared by this process has a number of important features as a consequence of the reaction between the tungsten and the epitaxial silicon surface, which results in the formation of a thin (less than 200 angstroms) layer of tungsten silicide at the interface between these two regions. Consequently, the tungsten is chemically bonded to the boron-doped silicon making for excellent adhesion. A subtractive tungsten process does not benefit from this result and unless stress is controlled carefully, the tungsten will often peel and crack due to poor adhesion.

An additional advantage of this process resides in the unexpected control over stress in the selectively deposited film. The stresses within the film can be controlled with good accuracy during deposition by varying temperature and pressure in the reactor. This ability to control stresses within the film is important, since stress control in a metal film allows control of the degree of distortions in the pattern. As is quite obvious, these distortions would otherwise be detrimental to the X-ray mask.

A third advantage of the selective CVD tungsten process of this invention is that it can be considered as a "dry" process. By way of contrast, absorber metal is usually additively patterned on a silicon membrane from a liquid bath, e.g., electroplating of gold. Liquids are far more difficult to keep ultra clean from microcontaminants, whereas gas phase reactions are relatively simple to keep clean.

The foregoing processing steps and materials of this invention result in a dimensionally stable mask which is extremely resistant to damage upon thermal expansion and contraction. The stability is due in part to the fact that the coefficient of thermal expansion of tungsten is the closest match to that of silicon. Consequently, distortions resulting from thermal mismatches are minimized. This is critical to the durability of the mask. During X-ray exposure, significant energy is absorbed by the mask generating heat which will cause thermal expansion of the mask. The distortions caused by thermal expansion and contraction can induce the mask to rupture much like concrete will crack over time due to constant expansion and contraction. Having an absorber and a membrane that expand and contract essentially in unison will minimize this effect. By way of contrast, additive gold absorber patterns have a very poor thermal expansion match to silicon and, therefore, do not exhibit a mask longevity comparable to additive tungsten over silicon.

EXAMPLE:

The following example illustrates the preparation of an X-ray mask according to the process of this invention. The example which follows is illustrative of the preparation of an X-ray mask by first defining the membrane area on a silicon wafer. This example, thus, follows the right hand processing pathway illustrated in Figure 3.

Initially, double polished silicon wafers are obtained commercially (Aurel Company, Santa Clara, California) having the following specifications:

        Orientation:  100
        Dopant Type:  N
        Resistivity:  2-2.5 Ohm-centimeters

Diameter: Two inches

These silicon wafers are then commercially processed to effect the growth of a boron-doped epitaxial silicon membrane on the upper surface thereof (M/A Com, burlington, Massachusetts). The resultant processing provides a membrane of a thickness from about 0.5 to 3 micrometers with a boron dopant concentration of $5 \times 10^{19}$ to $1 \times 1020$ boron atoms/$cm^3$.

A silicon dioxide coating is then deposited on both the upper surface of the membrane and on the underside of the wafer by chemical vapour deposition. The thickness of this silicon dioxide coating or stencil layer, is about 3000 angstroms. The apparatus used in this coating procedure is commercially available and the technique for effecting such deposit described in the open literature (Pyrox instrument, available from Tempress, a division of General Signal, Los Gatos, California).

A spin photoresist coating is now applied to both front and back surfaces of the silicon dioxide coating on the wafer. The photoresist is applied to the silicon dioxide surface of the wafer using a Shipley Microposit 1450J (available from the Shipley Company in Newton, Massachusetts). The equipment is operated to spin the wafer at 4000 rpm for about 30 seconds. The resist which results from this application technique is approximately 1.75 micrometers in thickness. The resist is baked for 30 minutes at approximately 90°C in a convection oven to effect curing. Following curing of the resist, it is exposed to ultraviolet light to define the membrane area. The exposure is for approximatley 45 seconds, using a 360 watt energy source and a conventional proximity mask to define the membrane area. The resist is then developed in a conventional developer solution (5 parts $H_2O$, 1 part

Shipley Microposit 351 developer concentrate). Development requires about 15 seconds and the developer is applied by conventional spray techniques.

Following development, the exposed portion of the silicon dioxide coating on the undrside of the wafer is removed by reactive ion etching (RIE) utilising trifluoromethane gas. The exposed portion of silicon dioxide coating is totally removed by RIE to the level of the silicon wafer. The apparatus used in this etching process is a converted Perkin-Elmer sputtering system (Model 3140). The process parameters are as follows:

600 volts bias

10 SCCM flow rate

10 millTorr pressure

Etch rate of $SiO_2$ approximately 300 angstroms/min.

Following this RIE procedure, the remaining portion of the resist is removed from both the top surface and the underside of this structure by stripping with an acetone rinse. The exposed regions of the silicon wafer are now chemically etched with a solution comprising ethylene diamine, pyrocatechol and $H_2O$. The relative concentration of these ingredients in the etching bath is as follows, 250 ml:45 gm:120 ml, This etchant is commercially available in premixed form (Transene Company, Rowley, Massachusetts). The etchant is effective to remove the silicon wafer at the rate of approximately 0.75 micrometers/min. The boron-doped epitaxial silicon membrane provides an effective barrier to erosion of this membrane.

Following definition of the membrane, a tri-level resist is applied to the intact silicon dioxide coating which covers the topside of the epitaxial silicon membrane. This tri-level resist is prepared by sequentially depositing, upon the silicon dioxide coating, three separate layers, the first being a Shipley Microposit 1450J photoresist (to a thickness of between 0.5 tol micrometer) curing the resist in the conventional manner followed thereafter by sputtering a silicon dioxide coating thereupon (to a thickness of between 250 and 500 angstrom units) thereafter applying on top of the $SiO_2$ layer, a polymethyl methacrylate coating by similar spin deposit techniques. The polymethyl methacrylate coating is cured by heating to about 180°C for 30 minutes. Following preparation of this tri-level resist, it is exposed to a pattern of electron beam energy. The device used in this exposure step is available from Perkin-Elmer, Haywood, California and is referred to as a MEBES.

Following such exposure, the surface of the tri-layer resist is develped with an 80-40 KTI polymethyl methacrylate developer (KTI Chemicals, Inc., Wallingford, Connecticut). The development cycle can range anywhere from 30-60 seconds, depending upon the duration of the exposure.

Following development of the tri-layer resist, the exposed $SiO_2$ layer is removed by reactive ion etching techniques (RIE). This procedure is similar to that used in removal of the silicon dioxide coating from the underside of the wafer in the definition of the membrane. The silicon dioxide, in the exposed areas, is removed to the level of the underlying boron-doped epitaxial silicon membrane, thereby forming a stencil. Upon completion of this etching process, the balance of the tri-layer resist is removed with an acetone rinse. The surface of the stencil and the exposed regions of the boron-doped epitaxial silicon layer are now cleaned with trichloroethylene followed by acetone and then a methanol rinse. The resultant structure is exposed to a plasma ash in a helium oxygen atmosphere (300 millitorr) utilising conventional equipment and techniques (equipment available from Technics Company, Providence, Rhode Island).

The surface of the stencil and the exposed regions of the boron-doped epitaxial silicon layer are now contacted with hydrofluoric acid prior to selective chemical vapour deposition of tungsten. The solution used in this cleansing operation is a buffered hydrofluoric acid which is commercially available (Transene Company, Rowley, Massachusetts). The duration of contact with the hydrofluoric acid is approximately 10-30 seconds per dip.

Following this final cleaning step, the structure is placed in a chemical deposition chamber and tungsten deposited onto the boron-doped epitaxial layer to a depth of between about 0.25 and about 0.4 micrometers. The tungsten deposit conforms to the contour of the silicon dioxide stencil. The equipment used in this procedure is readily commercially available (Genus, Inc., Mountain View, California or Anicon, San Jose, California).

Following the deposition of tungsten onto the doped epitaxial silicon layer, the silicon dioxide stencil is removed by dipping the surface of the resultant structure in buffered hydrofluoric acid until the balance of the silicon dioxide stencil is etched away. The duration of such immersion depends on the thickness of the $SiO_2$ layer; the etching rate is approximately 100 angstroms/min.

Following removal of the silicon dioxide stencil, the mask is washed for removal of residual acid and dried. The mask is now complete and can be used in fabrication of fine feature components for the microelectronics industry.

Claims:

1. A method of making a dimensionally stable X-ray mask comprising the steps of producing a mask blank consisting of a support member (4) on which is formed a membrane (6) of a material which is substantially transparent to X-rays, overlaying the membrane (6) with a stencil layer (8) of etchable material, selectively removing etchable material from the said stencil layer (8) by etching out a selected pattern therefrom, and depositing an X-ray absorbing material (10) onto the surface of the said membrane (6) exposed through the said etchable stencil layer (8) to form an X-ray absorbing pattern, characterised in that the said X-ray absorbing material (10) is selectively deposited by chemical vapour deposition techniques in a pattern determined by the etched pattern in the said stencil layer (8) under conditions such as to form a bonding reaction product between the mebrane and the X-ray absorbing material.

2. A method according to Claim 1, characterised in that the said membrane (6) is composed of a boron-doped silicon material and the said X-ray absorbing material (10) is tungsten.

3. A method according to Claim 2, characterised in that the concentration of boron in the said membrane (6) is in the range between about $5 \times 10^{19}/cm^3$ and about $2 \times 10^{20}/cm^3$.

4. A method according to any of Claims 1, 2 or 3 characterised in that the thickness of the said membrane (6) is between 0.5 and 3.0 micrometers, and the step of selectively depositing the X-ray absorbing material is limited to depositing the X-ray absorbing material (10) to a depth of not more than 0.75 micrometers.

5. A method according to any preceding Claim, characterised in that the mask blank is produced by growing an eptiaxial layer (6) on a first face of a silicon substrate (4), depositing a stencil layer (8) of etchable material over the said epitaxial layer (6), removing selected portions of the said stencil layer (8) to define the said pattern, and etching away the said substrate (4) from the face thereof opposite that on which the said epitaxial layer (6) is located whereby to expose the said epitaxial layer over an area greater than the area covered by the said pattern.

6.    A method according to any preceding Claim, characterised in that said membrane (6) is a boron-doped silicon material, the said X-ray absorbing material (19) is tungsten, and the said reaction product between the membrane (6) and the X-ray absorbing material is tungsten silicide.

7.    A method according to Claim 5 or Claim 6, characterised in that the etching of the substrate (4) from the face thereof opposite that on which the said epitaxial layer is formed is effected prior to the selective deposition onto the said membrane (6) of the said X-ray absorbing material.

8.    A method according to Claim 7, characterised in that the etching of the said substrate (4) from the face thereof opposite that on which the said epitaxial layer is formed is effected prior to the formation of the said pattern on the said etchable stencil layer (8).

FIG.1

FIG.2

FIG.3a

FIG.3b

FIG.3c

FIG.3d